# EUROPÄISCHE PATENTSCHRIFT

(11) **EP 0 942 474 B1**
(45) Veröffentlichungstag und Bekanntmachung des Hinweises auf die Patenterteilung: **19.04.2006**
(21) Anmeldenummer: 99103653.4
(22) Anmeldetag: 25.02.1999
(51) Int. Cl.: H01L 33/00, H05B 33/08, H01L 25/16

(54) **Leuchtdiode**
Light emitting diode
Diode émettrice de lumière

(30) Priorität: 11.03.1998 DE 19810308; 01.04.1998 DE 19814495
(43) Veröffentlichungstag der Anmeldung: 15.09.1999
(73) Patentinhaber: SIEMENS AKTIENGESELLSCHAFT, 80333 München (DE)
(72) Erfinder: Jansa, Frank, 60385 Frankfurt (DE); Olbrich, Helmut, 65287 Darmstadt (DE); Noll, Heinrich, Dr., 64823 Gross-Umstadt (DE); Vogel, Michael, 60437 Frankfurt (DE)

(56) Entgegenhaltungen:
- US-A- 4 157 486
- US-A- 5 724 055
- PATENT ABSTRACTS OF JAPAN vol. 016, no. 401 (E-1253), 25. August 1992 (1992-08-25) & JP 04 132275 A (ROHM CO LTD), 6. Mai 1992 (1992-05-06)
- PATENT ABSTRACTS OF JAPAN vol. 008, no. 235 (E-275), 27. Oktober 1984 (1984-10-27) & JP 59 117280 A (RICOH KK), 6. Juli 1984 (1984-07-06)
- PATENT ABSTRACTS OF JAPAN vol. 014, no. 032 (E-876), 22. Januar 1990 (1990-01-22) & JP 01 268074 A (HITACHI LTD), 25. Oktober 1989 (1989-10-25)
- PATENT ABSTRACTS OF JAPAN vol. 012, no. 174 (E-612), 24. Mai 1988 (1988-05-24) & JP 62 282472 A (MATSUSHITA GRAPIC INC), 8. Dezember 1987 (1987-12-08)

## Beschreibung

Die Erfindung betrifft eine Leuchtdiode mit einer Codierung für unterschiedliche Lichtstärkeklassen, und mit einem Anschlusselement mit wenigstens zwei elektrischen Kontaktelementen zum Anschluß einer Energieversorgung.

Solche auch als Lumineszenzdioden bekannten Leuchtdioden (LED) werden in der Praxis häufig zur Beleuchtung im Bereich der Armaturentafel eines Kraftfahrzeuges eingesetzt und dienen beispielsweise als Signal- oder Kontrollleuchte, aber auch zunehmend zur Beleuchtung von Zifferblättern. Leuchtdioden werden besonders wegen ihrer im Vergleich zu Glühlampen geringen Störanfälligkeit sowie ihres verhältnismäßig geringen Energieverbrauches bevorzugt eingesetzt. Hierzu hat neben der Realisierung nahezu beliebiger Farbgebungen vor allem auch eine erheblich gesteigerte Lichtstärke beigetragen. Bereits heute sind Leuchtdioden erhältlich, deren Lichtstärke ausreichend ist, um beispielsweise Bremslichter eines Kraftfahrzeuges damit auszurüsten.

Schwierigkeiten bei der Nutzung der Leuchtdioden bereitet in der Praxis die im Herstellungsprozess nicht exakt vorherbestimmbare Lichtstärke. So schwanken die Lichtstärken verschiedener Leuchtdioden, die beispielsweise auch aus demselben Los stammen können, trotz konstanter Spannung und Stromaufnahme. Je nach Anwendungsgebiet wirft dies erhebliche Probleme auf. Beispielsweise verschlechtert sich die Ablesegenauigkeit bei den mit solchen Leuchtdioden ausgerüsteten Anzeigevorrichtungen und es entsteht durch diese Helligkeitsschwankungen mehrerer nebeneinander angeordneter Leuchtdioden ein minderwertiger Eindruck.

Bisher versucht man diesem Problem dadurch zu begegnen, dass die Lichtstärke der verschiedenen Leuchtdioden während des Herstellungsprozesses gemessen wird und die Leuchtdioden anschließend mit einer Codierung versehen werden, welche die Lichtstärkeklasse bezeichnet. Diese Codierung besteht hierbei zumeist aus einem Barcode, welcher an der Leuchtdiode oder einem mit der Leuchtdiode verbundenen Anschlusselement angebracht wird. Bei der Montage der Leuchtdiode wird dann zunächst die Codierung gelesen und je nach Lichtstärkeklasse ein Vorwiderstand ausgewählt und der Leuchtdiode vorgeschaltet, so dass eine annähernd gleichbleibende Lichtstärke verschiedener Leuchtdioden eines Typs gewährleistet wird.

Hierbei wirkt sich vor allem der erhebliche Aufwand nachteilig aus, der erforderlich ist, den Barcode zu erfassen und anschließend einen entsprechenden Vorwiderstand der Leuchtdiode vorzuschalten. Weiterhin müssen der Vorwiderstand und die Leuchtdiode aufgrund der individuellen Abstimmung aufeinander bei einem gegebenenfalls erforderlichen Austausch immer zusammen ausgetauscht werden. Aber auch bei der Herstellung des die Leuchtdiode aufweisenden Bauteils entsteht zusätzlicher Aufwand, da die Leuchtdiode und der entsprechende Vorwiderstand eine untrennbare Einheit bilden.

Man könnte daran denken, einen entsprechenden Vorwiderstand bereits bei der Herstellung der Leuchtdiode zu integrieren. Dies führt jedoch dazu, dass der Anwendungsbereich vor allem durch die gegenüber bekannten Leuchtdioden geänderten Abmessungen bereits eingeschränkt ist.

Der Erfindung liegt daher das Problem zugrunde, eine Leuchtdiode derart auszuführen, dass der Ausgleich verschiedener möglicher Lichtstärkeklassen der Leuchtdiode bei der Montage selbsttätig, d.h. ohne vorhergehendes Lesen der Codierung und anschließende Auswahl und Bestückung des entsprechenden Vorwiderstandes erfolgen kann.

Dieses Problem wird erfindungsgemäß dadurch gelöst, dass das Anschlusselement zumindest ein weiteres elektrisches Kontaktelement besitzt und dass die Codierung dadurch erreicht wird, dass mit dem zumindest einen weiteren Kontaktelement eine elektrische Verbindung entweder geschlossen oder unterbrochen ist. Hierdurch wird die Leuchtdiode bereits durch Anschluss der Kontaktelemente genau mit demjenigen elektrischen oder elektronischen Bauteil verbunden, welches für den Ausgleich der Lichtstärkeklasse geeignet ist. Ein vorhergehendes Erfassen eines Barcodes kann hierdurch entfallen. Die zum Ausgleich der Lichtstärkeklassen der verschiedenen Leuchtdioden erforderlichen elektrischen oder elektronischen Bauteile können hierdurch an den mit der Leuchtdiode zu verbindenden Bauteilen, z.B. einer Leiterplatte eines Kombinationsinstrumentes eines Kraftfahrzeugs, bereits fest montiert sein und werden durch die Kontaktelemente automatisch entsprechend der durch die Codierung vorgegebenen Lichtstärkeklasse angeschlossen. Weiterhin wird der gegebenenfalls erforderliche Austausch von Leuchtdioden wesentlich erleichtert, da die Lichtstärkeklasse der neuen Leuchtdiode automatisch erfasst und korrigiert wird. Die Kenntnis der Lichtstärkeklasse der ursprünglichen Leuchtdiode ist daher nicht erforderlich, womit es auch dem Laien möglich wird, den Austausch vorzunehmen.

Eine besonders einfache Ausführungsform der Erfindung ist hierbei gegeben, wenn wenigstens eines der Kontaktelemente mit einem Vorwiderstand verbunden ist. Im Vergleich zu bekannten Leuchtdioden, bei denen der entsprechende Vorwiderstand eigens für die Leuchtdiode bestückt wird, ist bei der vorliegenden Erfindung ein möglicherweise erforderlicher Vorwiderstand bereits vorhanden. Welcher Vorwiderstand mit der Leuchtdiode verbunden wird, ist durch die Codierung der Kontaktelemente bestimmt.

Die für den Lichtstärkeausgleich erforderlichen Bauteile könnten in einem zu dem Anschlusselement kompatiblen Kupplungselement integriert sein. Besonders günstig ist es jedoch, wenn die Leuchtdiode mit einer Leiterfolie oder Leiterplatte verbunden ist. Hierdurch lassen sich die Bauteile weitgehend vormontieren und standardisieren. Dabei lassen sich größere Stückzahlen erzielen und zugleich die Herstellungskosten reduzieren. In einfacher Weise ist es dann auch möglich, mehrere Leuchtdioden zur Lichtstärkeerhöhung gemeinsam anzuordnen und entsprechend mit einer einzigen Codierung zu versehen. Vorteilhaft gehören diese zusammengefaßten Leuchtdioden jeweils derselben Lichtstärkeklasse an.

Eine andere, besonders vorteilhafte Ausführungsform der Erfindung ist gegeben, wenn die Codierung für ein Steuerelement lesbar ausgeführt ist. Hierbei wird die Codierung zunächst mittels des Steuerelementes erfasst und daraus die für den Lichtstärkeausgleich erforderlichen Daten ermittelt. Der zum Betrieb der Leuchtdiode erforderliche Strom kann daher unabhängig von dem zur Erfassung der Codierung erforderlichen Stromkreis eingeleitet werden. Fehlerhafte Kontaktelemente führen daher nicht zu einem Ausfall der Stromversorgung der Leuchtdiode. Es können darüber hinaus auch Lichtstärkeklassen weiterer Leuchtdioden in einem einzigen zentralen Steuerelement erfasst und miteinander verglichen werden.

Die bei dieser Anordnung erforderliche Anpassung der Lichtstärkeklasse kann besonders leicht erreicht werden, wenn die Leuchtdiode einen Vorwiderstand aufweist, der in Abhängigkeit von der Codierung mittels des Steuerelementes vorschaltbar ist. Hierdurch lässt sich eine hohe Betriebssicherheit erreichen. Gleichzeitig ist es durch diese Anordnung möglich, bei Verwendung mehrerer Leuchtdioden der gleichen Lichtstärkeklasse einen gemeinsamen Vorwiderstand vorzusehen.

Eine besonders vorteilhafte Weiterbildung gestattet einen Betrieb ohne einen Vorwiderstand, wenn die Stromversorgung der Leuchtdiode mittels des Steuerelementes in Abhängigkeit von der Codierung einstellbar ist. Hierbei sorgt vorzugsweise eine Pulsweitensteuerung für eine Anpassung der Stromversorgung an die jeweilige Lichtstärkeklasse der Leuchtdiode. Auf zusätzliche Vorwiderstände kann daher verzichtet werden.

Eine andere vorteilhafte Weiterbildung der Erfindung ist gegeben, wenn die Codierung durch eine Unterbrechung von elektrischen Verbindungen zwischen Kontaktelementen untereinander oder von elektrischen Verbindungen zwischen der Leuchtdiode und Kontaktelementen gegeben ist. Hierbei können im Herstellungsprozess zunächst alle elektrischen Verbindungen zwischen Kontaktelementen geschlossen sein. Nach Messung der Lichtstärke können dann einzelne oder auch mehrere elektrische Verbindungen durchbrochen und so eine Codierung erreicht werden. Beispielsweise können die Kontaktelemente und ihre Verbindungen untereinander auch aus einer flexiblen Leiterplatte oder einer Leiterfolie bestehen, deren Leiterbahnen einfach durch Ausstanzen oder Lochen unterbrochen werden können, so dass eine schnelle und zuverlässige Codierung durchgeführt werden kann.

Gemäß einer besonders vorteilhaften Weiterbildung der Erfindung ist die Leuchtdiode mit einem Zeiger eines Zeigerinstrumentes drehfest verbunden. Auf diese Weise kann die Leuchtdiode einer aktiven Beleuchtung des Zeigers dienen, wodurch dessen Wahrnehmbarkeit, insbesondere nachts, erheblich gesteigert wird. Aufgrund der Codierung, die analog oder digital sein kann, ist zuverlässig gewährleistet, dass die Zeigerbeleuchtung eine vordefinierte Helligkeit aufweist. Besonders günstig ist es bei dieser Ausführung, wenn die Leuchtdiode mit einer Leiterfolie zur Versorgung mit elektrischer Energie elektrisch verbunden ist, da die Leiterfolie eine verschleißfreie Kontaktierung der Leuchtdiode bietet und zudem eine Drehbewegung des Zeigers nicht behindert.

Die Erfindung lässt zahlreiche Ausführungsformen zu. Zur weiteren Verdeutlichung ihres Grundprinzips ist eine davon in der Zeichnung dargestellt und wird nachfolgend beschrieben. Diese zeigt in
- Fig. 1: ein Schaltbild einer erfindungsgemäßen Leuchtdiode mit mehreren Vorwiderständen,
- Fig. 2: ein Schaltbild der erfindungsgemäßen Leuchtdiode mit einem angeschlossenen Steuerelement,
- Fig. 3: eine geschnittene Seitenansicht eines Zeigerinstrumentes mit einer erfindungsgemäßen Leuchtdiode.

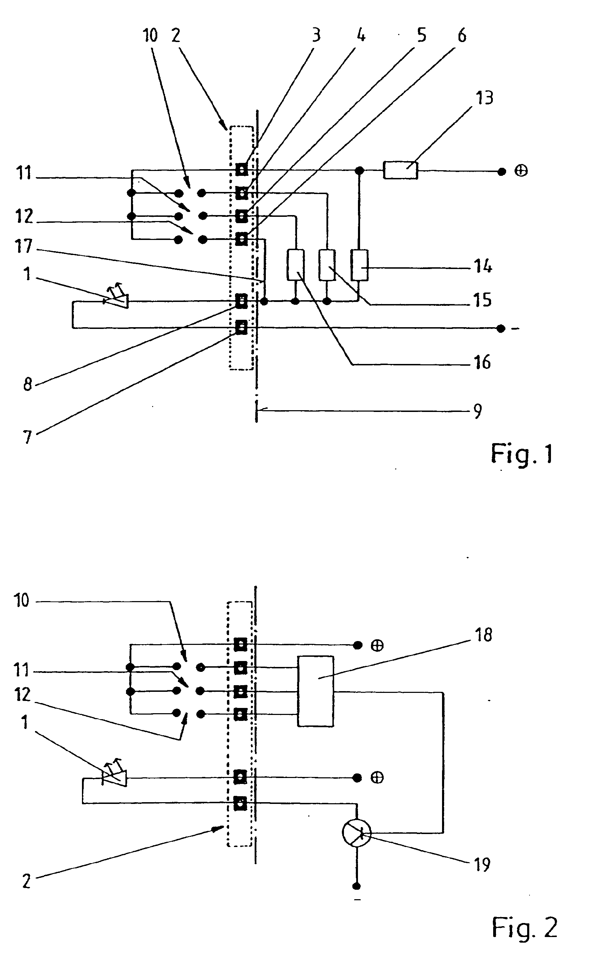

Die Figur 1 zeigt ein Schaltbild einer erfindungsgemäßen Leuchtdiode 1. Entlang eines lediglich schematisch dargestellten Anschlusselementes 2 mit sechs Kontaktelementen 3 - 8 verläuft eine gestrichelt dargestellte Trennlinie 9. Die Leuchtdiode 1 bildet zusammen mit den innerhalb des als Stecker ausgeführten Anschlusselementes 2 angeordneten Kontaktelementen 3 - 8 eine bauliche Einheit, welche mechanisch von den übrigen Bauteilen entlang der Trennlinie 9, die eine Steckverbindung symbolisiert, trennbar angeordnet ist. Die bauliche Einheit, die z.B. von einer flexiblen Leiterfolie, auf der die Leuchtdiode 1 aufkontaktiert ist und die mit dem Stecker versehen ist, gebildet wird, umfasst weiterhin elektrische Kontaktstellen 10, 11, 12, die in der dargestellten Ausführung unterbrochen sind und so eine Codierung der Lichtstärkeklasse der Leuchtdiode 1 festlegen. Der Leuchtdiode 1 sind zwei in Reihe geschaltete Vorwiderstände 13 und 14 vorgeschaltet. Werden eine oder mehrere der Kontaktstellen 10, 11 oder 12 geschlossen, so reduziert sich der Gesamtwiderstand. Codierungen führen z.B. zu einer elektrischen Verbindung mit Vorwiderständen 15, 16 oder ermöglichen eine direkte Verbindung 17. Die Vorwiderstände 13 - 16 sind dabei außerhalb der baulichen Einheit der mit der Leuchtdiode 1 verbundenen Kontaktelemente 3 - 8 und des Anschlusselementes 2 z.B. auf einer Leiterplatte angeordnet und müssen somit bei einem Austausch der Leuchtdiode 1 nicht entfernt werden. Es ist zu erkennen, dass die Kontaktelemente 7, 8 einer unmittelbaren Versorgung der Leuchtdiode 1 mit elektrischer Energie dienen, wohingegen über die Kontaktelemente 3 - 6 die Codierung umgesetzt wird.

Figur 2 zeigt ein Schaltbild der in Figur 1 dargestellten Leuchtdiode 1, die in diesem Fall mittels des Anschlusselementes 2 mit einem als Logikschaltung ausgeführten Steuerelement 18 verbunden ist. In diesem Fall erkennt das Steuerelement 18, z.B. ein Microprozessor, die durch Unterbrechung der Kontaktstellen 10, 11, 12 gegebene Codierung der Lichtstärkeklasse der Leuchtdiode 1 und steuert auf diese Weise über ein als Transistor ausgeführtes, elektronisches Bauteil 19 die für die entsprechende Lichtstärkeklasse erforderliche Stromversorgung der Leuchtdiode 1.

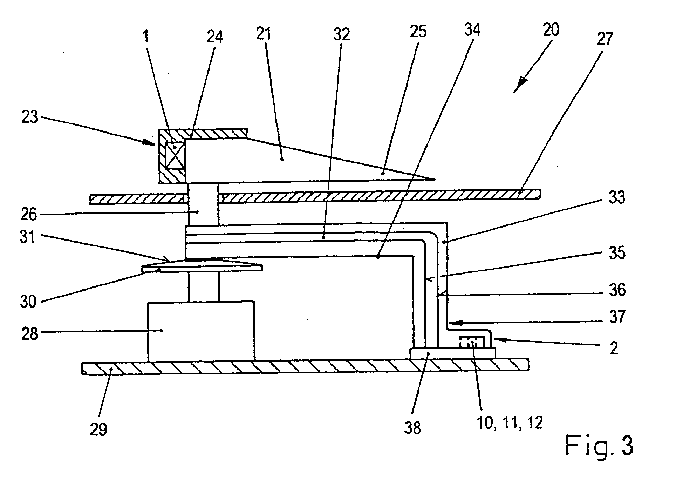

Figur 3 zeigt in einer vereinfachten Darstellung ein Zeigerinstrument 20 mit einem eine Zeigerfahne 21 aufweisenden Zeiger 23. In diese Zeigerfahne 21 strahlt eine als Leuchtdiode 1 ausgeführte Lichtquelle Licht ein, welche gegenüber einem möglichen Betrachter mit einer Kappe 24 abgedeckt ist. Die Zeigerfahne 21 ist an ihrem einer Zeigerspitze 25 gegenüberliegenden Ende an der Unterseite mit einer Zeigerwelle 26 verbunden, welche durch ein Zifferblatt 27 hindurchgeführt ist und mittels eines als Messwerk ausgeführten Zeigerantriebes 28 auslenkbar ist. Zwischen einer den Zeigerantrieb 28 tragenden Leiterplatte 29 und dem Zifferblatt 27 besitzt die Zeigerwelle 26 eine flanschartige Erweiterung 30, welche eine nach außen hin abfallende Schrägfläche 31 hat. Gegen die Erweiterung 30 liegt ein Abschnitt eines aufwickelbaren mittleren Bereichs 32 einer um die Zeigerwelle 26 spiralförmig herumgeführten Leiterfolie 33 mit einer unteren Seitenkante 34 an. Die mit zwei Leiterbahnen 35, 36 zur Verbindung der Leuchtdiode 1 mit einer Energieversorgung versehene Folie 33 ist gegenüber der Zeigerwelle 26 in etwa rechtwinklig nach außen geführt und weist in ihrem der Zeigerwelle 26 abgewandten Endbereich einen verstärkt ausgeführten Abschnitt 37 auf, der nach unten geführt ist. Dieser verstärkte Abschnitt 37 hat ein als Steckverbindung 38 ausgebildetes Anschlußelement 2 mittels welcher Steckverbindung 38 die Folie 33 mit der die Stromversorgung bildende Leiterplatte 29 verbunden ist. Nicht dargestellt ist die in einer Ausnehmung der Zeigerwelle 26 verlaufende, einteilige Verbindung der Folie 33 mit der Leuchtdiode 1.

Kontaktstellen 10, 11, 12, die eine Codierung der Leuchtdiode 1 festlegen, sind im Bereich der Steckverbindung 38 angeordnet und mit innerhalb des Anschlußelementes 2 angeordneten, hier nicht dargestellten Kontaktelementen entsprechend Figur 1 verbunden. Ebenfalls nicht dargestellte und innerhalb des Anschlußelementes 2 angeordnete Kontaktelemente, die den Kontaktelementen 7, 8 in Figur 1 entsprechen, sind mit den Leiterbahnen 35, 36 verbunden und versorgen die Leuchtdiode 1 mit elektrischer Energie.

## Patentansprüche

1. Leuchtdiode (1) mit einer Codierung für unterschiedliche Lichtstärkeklassen, und mit einem Anschlusselement (2) mit wenigstens zwei elektrischen Kontaktelementen (7, 8) zum Anschluß einer Energieversorgung, **dadurch gekennzeichnet, dass** das Anschlusselement (2) zumindest ein weiteres elektrisches Kontaktelement (3 - 6) besitzt und dass die Codierung **dadurch** erreicht wird, dass mit dem zumindest einen weiteren Kontaktelement (3 - 6) eine elektrische Verbindung entweder geschlossen oder unterbrochen ist.

2. Leuchtdiode nach Anspruch 1, **dadurch gekennzeichnet, dass** wenigstens eines der Kontaktelemente (3 - 8) mit einem Vorwiderstand (13 - 16) verbunden ist.

3. Leuchtdiode nach Anspruch 1 oder 2, **dadurch gekennzeichnet, dass** die Leuchtdiode (1) mit einer Leiterfolie oder Leiterplatte verbunden ist.

4. Leuchtdiode nach einem der vorhergehenden Ansprüche, **dadurch gekennzeichnet, dass** die Codierung für ein Steuerelement (18) lesbar ausgeführt ist.

5. Leuchtdiode nach einem der vorhergehenden Ansprüche, **dadurch gekennzeichnet, dass** die Leuchtdiode (1) einen Vorwiderstand (13 - 16) aufweist, der in Abhängigkeit von der Codierung mittels des Steuerelementes (18) vorschaltbar ist.

6. Leuchtdiode nach einem der vorhergehenden Ansprüche, **dadurch gekennzeichnet, dass** die Stromversorgung der Leuchtdiode (1) mittels des Steuerelementes (18) in Abhängigkeit von der Codierung einstellbar ist.

7. Leuchtdiode nach einem der vorhergehenden Ansprüche, **dadurch gekennzeichnet, dass** die Codierung durch eine Unterbrechung von elektrischen Verbindungen zwischen Kontaktelementen (3 - 8) untereinander oder von elektrischen Verbindungen zwischen der Leuchtdiode (1) und Kontaktelementen (3 - 8) gegeben ist.

8. Leuchtdiode nach einem der vorhergehenden Ansprüche, **dadurch gekennzeichnet, dass** die Leuchtdiode (1) mit einem Zeiger (23) eines Zeigerinstrumentes (20) drehfest verbunden ist.

9. Leuchtdiode nach Anspruch 8, **dadurch gekennzeichnet, dass** die Leuchtdiode (1) mit einer Leiterfolie (33) elektrisch verbunden ist.

## Claims

1. Light-emitting diode (1) having a code for different light intensity classes, and having a connection element (2) with at least two electrical contact elements (7, 8) for connecting a power supply, **characterized in that** the connection element (2) has at least one further electrical contact element (3 - 6) and **in that** the code is produced by using the at least one further contact element (3 - 6) either to make or break an electrical connection.

2. Light-emitting diode according to Claim 1, **characterized in that** at least one of the contact elements (3 - 8) is connected to a series resistor (13 - 16).

3. Light-emitting diode according to Claim 1 or 2, **characterized in that** Light-emitting diode (1) is connected to a ribbon conductor or printed circuit board.

4. Light-emitting diode according to one of the preceding claims, **characterized in that** the code is designed so that it can be read by a control element (18).

5. Light-emitting diode according to one of the preceding claims, **characterized in that** Light-emitting diode (1) has a series resistor (13 - 16) which can be connected upstream as a function of the code, using the control element (18).

6. Light-emitting diode according to one of the preceding claims, **characterized in that** the power supply for Light-emitting diode (1) can be set as a function of the code, using the control element (18).

7. Light-emitting diode according to one of the preceding claims, **characterized in that** the code is produced by interrupting electrical connections between individual contact elements (3 - 8) or by interrupting electrical connections between Light-emitting diode (1) and contact elements (3 - 8).

8. Light-emitting diode according to one of the preceding claims, **characterized in that** Light-emitting diode (1) is connected to a pointer (23) of a dial instrument (20) such that they rotate together.

9. Light-emitting diode according to claim 8, **characterized in that** Light-emitting diode (1) is electrically connected to a ribbon conductor (33).

## Revendications

1. Diode électroluminescente (1) comportant une codification pour des classes différentes d'intensité lumineuse et un élément de raccordement (2) ayant au moins deux éléments de contact électriques (7, 8) permettant son raccordement à une alimentation en énergie, **caractérisée par le fait que** l'élément de raccordement (2) a au moins un autre élément de contact électrique (3 - 6) et que la codification est obtenue **par le fait qu'**une liaison électrique est ou bien fermée ou bien ouverte par le au moins un autre élément de contact électrique (3 - 6).

2. Diode électroluminescente selon la revendication 1 **caractérisée par le fait que** au moins l'un des éléments de contact (3 - 8) est relié à une résistance série (13 - 16).

3. Diode électroluminescente selon la revendication 1 ou 2 **caractérisée par le fait que** la diode électroluminescente (1) est reliée à une membrane conductive ou à une carte à circuits imprimés.

4. Diode électroluminescente selon l'une des revendications précédentes **caractérisée par le fait que** la codification est conçue pour pouvoir être lue par un élément de commande (18).

5. Diode électroluminescente selon l'une des revendications précédentes **caractérisée par le fait que** la diode électroluminescente (1) comporte une résistance série (13 - 16) qui peut être connectée au moyen de l'élément de commande (18) en fonction de la codification.

6. Diode électroluminescente selon l'une des revendications précédentes **caractérisée par le fait que** l'alimentation en courant de la diode électroluminescente (1) est réglable au moyen de l'élément de commande (18) en fonction de la codification.

7. Diode électroluminescente selon l'une des revendications précédentes **caractérisée par le fait que** la codification est donnée par une interruption de liaisons électriques entre des éléments de contact (3 - 8) et de liaisons électriques entre la diode électroluminescente (1) et des éléments de contact (3 - 8) .

8. Diode électroluminescente selon l'une des revendications précédentes **caractérisée par le fait que** la diode électroluminescente (1) est liée en blocage de rotation à une aiguille (23) d'un instrument à aiguille (20).

9. Diode électroluminescente selon la revendication 8 **caractérisée par le fait que** la diode électroluminescente (1) est reliée électriquement à une membrane conductive (33).
